# EUROPEAN PATENT APPLICATION

(11) **EP 4 716 035 A1**
(43) Date of publication of application: **25.03.2026**
(21) Application number: 25175574.0
(22) Date of filing: 12.05.2025
(51) Int. Cl.: H01S 5/042, H01S 5/068, H01S 5/026, H01S 5/183

(54) **LIGHT EMITTING DEVICE AND MANUFACTURING METHOD THEREOF**

(30) Priority: 23.09.2024 TW 113136024
(71) Applicant: Taiwan-Asia Semiconductor Corporation, Hsinchu City 30078 (TW)
(72) Inventor: LIN, Kun-Li, 30078 Hsinchu City (TW); CHEN, Chuan-Wei, 30078 Hsinchu City (TW); LEE, Shang-Che, 30078 Hsinchu City (TW); CHEN, Huang-Ming, 30078 Hsinchu City (TW)
(74) Representative: Michalski Hüttermann & Partner Patentanwälte mbB

(57) **Abstract**

A light-emitting device and a manufacturing method thereof are provided. The light-emitting device includes an epitaxial layer with a first region and a second region longitudinally divided by a trench. The first contact electrode disposed on the epitaxial layer includes an opening electrically connected to the upper surface of the first region with a current confinement region below the opening. The Schottky interface is disposed on the upper surface of the first area outside the current confinement region, and forms a Schottky barrier between the interface and part of the first contact electrode. The first metal pad disposed under the second region extends longitudinally to electrically connect to the first contact electrode. The second contact electrode disposed on the epitaxial layer is electrically connected to the upper surface of the second region. The second metal pad disposed under the first region extends longitudinally to electrically connect the second contact electrode.

## Description

### BACKGROUND OF THE INVENTION

### Field of the Invention

The present invention relates to a light-emitting device and a manufacturing method thereof, and in particular to a bidirectional surge-resistant light-emitting device and a manufacturing method thereof.

### Descriptions of the Related Art

A vertical cavity surface emitting laser (VCSEL) device utilizes an oxide layer to confine current within a small region, known as the oxidation aperture (OA), in order to achieve high current density and reduce the threshold current. Since the oxide layer confines the current to a localized area, the VCSEL is relatively susceptible to electrical overstress (EOS), such as transient surge currents caused by hot swapping or improper test wiring, as well as electrostatic discharge (ESD) events.

In view of this, a critical challenge is preventing both forward and reverse surge currents from passing through the oxidation aperture to avoid damages in the OA region induced by EOS or ESD.

### SUMMARY OF THE INVENTION

The main objective of the present invention is to provide a light-emitting device and its manufacturing method for optimizing the circuitry and epitaxial layers based on the light-emitting device disclosed in Taiwan Patent Publication No. 202508169A. In addition to the original current path, the invention introduces dual pathways for both forward and reverse EOS/ESD dissipation for thereby enhancing EOS/ESD resistance without compromising the original light-emission efficiency.

To achieve the above objective, the present invention discloses a light-emitting device includes an epitaxial layer, a first contact electrode, a Schottky interface, a first metal pad, a second contact electrode and a second metal pad. The epitaxial layer has a trench, which longitudinally divides the epitaxial layer into a first region and a second region that are separated from each other. The first contact electrode is disposed on the epitaxial layer and includes an opening electrically connected to the upper surface of the first region, wherein the first region has a current confinement region below the opening. The Schottky interface is disposed on the upper surface of the first area outside the current confinement region, and forms a Schottky barrier between the interface and part of the first contact electrode. The first metal pad is disposed under the second region of the epitaxial layer and extends longitudinally to electrically connect to the first contact electrode. The second contact electrode is disposed on the epitaxial layer and is electrically connected to the upper surface of the second region. The second metal pad is disposed under the first region of the epitaxial layer and extends longitudinally to electrically connect the second contact electrode

In one embodiment of a light-emitting device of the present invention, when a forward surge current flows into the first metal pad and the first contact electrode, the forward surge current overcomes the Schottky barrier for causing most of the forward surge current to flow through the Schottky interface into the other region of the first region outside the current confinement region, and the rest of the forward surge current flows into the current confinement region.

In one embodiment of a light-emitting device of the present invention, when a reverse surge current flows into the second metal pad and the second contact electrode, the reverse surge current totally flows into the second region without reversely flowing into the current confinement region.

In one embodiment of a light-emitting device of the present invention, the Schottky interface is an indium gallium phosphide (InGaP) layer.

In one embodiment of a light-emitting device of the present invention, the light-emitting device further comprising an ohmic contact interface disposed on the epitaxial layer, wherein an ohmic contact is formed between the portion of the ohmic contact interface outside the Schottky interface and the first contact electrode.

In one embodiment of a light-emitting device of the present invention, the ohmic contact interface is a heavily doped gallium arsenide (GaAs) layer.

In one embodiment of a light-emitting device of the present invention, the epitaxial layer comprises an N-type epitaxial layer, a multiple quantum well layer, a P-type epitaxial layer and two current barrier layers. The multiple quantum well layer is disposed on the N-type epitaxial layer. The P-type epitaxial layer is disposed on the multiple quantum well layer. The two current barrier layers are disposed in the P-type epitaxial layer and laterally separated from each other by a distance, wherein the first metal pad is disposed under the N-type epitaxial layer in the second region, and the second metal pad is disposed under the N-type epitaxial layer in the first region, and wherein the ohmic contact interface is disposed on the P-type epitaxial layer.

In one embodiment of a light-emitting device of the present invention, the first region of the epitaxial layer has a first longitudinal through hole, and the second metal pad extends longitudinally along the first longitudinal through hole to be electrically connected to the second contact electrode.

In one embodiment of a light-emitting device of the present invention, the second region of the epitaxial layer has a second longitudinal through hole, and the first metal pad extends longitudinally along the second longitudinal through hole to be electrically connected to the first contact electrode.

In one embodiment of a light-emitting device of the present invention, the materials of the first contact electrode and the second contact electrode are selected from a group consisting of silver (Ag), titanium (Ti), platinum (Pt), germanium gold (GeAu), gold (Au) and combinations thereof.

To achieve the above objective, the present invention discloses a manufacturing method of a light-emitting device which comprises the following steps: providing an epitaxial layer; providing a Schottky interface, disposed on a portion of the epitaxial layer; providing a contact electrode, disposed on the Schottky interface and on the other portion of the epitaxial layer outside the Schottky interface; patterning the contact electrode to form a first contact electrode and a second contact electrode, wherein the first contact electrode has an opening and forms a Schottky barrier between the Schottky interface and a portion of the first contact electrode; providing a trench, longitudinally dividing the epitaxial layer into a first region and a second region separated from each other, wherein the first contact electrode is electrically connected to the upper surface of the first region, the second contact electrode is electrically connected to the upper surface of the second region, and the first region has a current confinement region below the opening; providing a first metal pad, disposed under the second region of the epitaxial layer and extending longitudinally to electrically connect to the first contact electrode; and providing a second metal pad, disposed under the first region of the epitaxial layer and extending longitudinally to electrically connect the second contact electrode.

In one embodiment of a manufacturing method of a light-emitting device of the present invention, the manufacturing method further comprises a step of providing an ohmic contact interface disposed on the epitaxial layer, wherein an ohmic contact is formed between the portion of the ohmic contact interface outside the Schottky interface and the first contact electrode before the step of providing a Schottky interface.

In one embodiment of a manufacturing method of a light-emitting device of the present invention, the step of providing a first metal pad is to fill a material selected from a group consisting of silver (Ag), titanium (Ti), platinum (Pt), germanium gold (GeAu), gold (Au) and their combinations thereof after providing a second longitudinal through hole penetrating the second region of the epitaxial layer.

In one embodiment of a manufacturing method of a light-emitting device of the present invention, the step of providing a second metal pad is to fill a material selected from one of a group consisting of silver (Ag), titanium (Ti), platinum (Pt), germanium gold (GeAu), gold (Au) and their combinations thereof after providing a first longitudinal through hole penetrating the first region of the epitaxial layer.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a perspective schematic view of a light-emitting device according to an embodiment of the present invention;
FIG. 2 is a cross-sectional schematic view of a light-emitting device according to an embodiment of the present invention;
FIG. 3A is a schematic view illustrating the current path of the light-emitting device during normal operation according to an embodiment of the present invention;
FIG. 3B is a schematic view of an equivalent circuit of the light-emitting device during normal operation according to an embodiment of the present invention;
FIG. 3C is a current-voltage characteristic diagram of the light-emitting device during normal operation according to an embodiment of the present invention;
FIG. 4A is a schematic view illustrating the current path of the light-emitting device under a forward surge current according to an embodiment of the present invention;
FIG. 4B is a schematic view of an equivalent circuit of the light-emitting device under a forward surge current according to an embodiment of the present invention;
FIG. 4C is a current-voltage characteristic diagram of the light-emitting device under a forward surge current according to an embodiment of the present invention;
FIG. 5A is a schematic view illustrating the current path of the light-emitting device under a reverse surge current according to an embodiment of the present invention;
FIG. 5B is a schematic view of an equivalent circuit of the light-emitting device under a reverse surge current according to an embodiment of the present invention;
FIG. 5C is a current-voltage characteristic diagram of the light-emitting device under a reverse surge current according to an embodiment of the present invention; and
FIG. 6 is a schematic view illustrating the process steps of the light-emitting device according to an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

The present invention relates to a light-emitting device, particularly to a flip-chip type VCSEL device and a manufacturing method thereof. The light-emitting device of the present invention has an epitaxial layer separated into two independent regions by a trench and a Schottky interface, utilizing the mesa structure in its flip-chip configuration to create two independent current paths for dissipating bidirectional surge currents for thereby protecting the structure of the VCSEL device during normal operation, as detailed below.

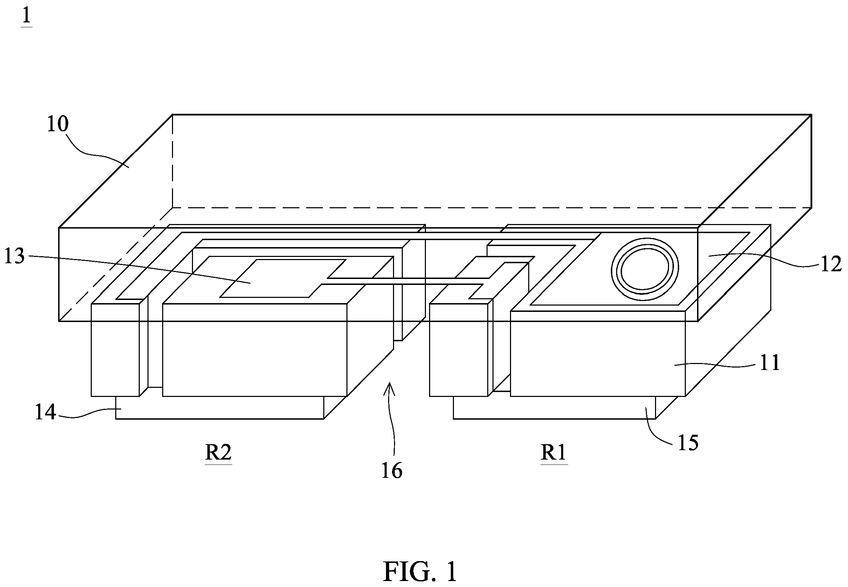

Please refer to FIG. 1, which shows a perspective schematic view of a light-emitting device in an embodiment of the present invention, having a flip-chip wafer structure, that is, the light-emitting device 1 is a vertical cavity surface emitting laser (VCSEL) flip-chip. As shown in FIG. 1, the light-emitting device 1 of the present invention comprises a substrate 10, an epitaxial layer 11, a first contact electrode 12, a second contact electrode 13, a first metal pad 14, and a second metal pad 15. The substrate 10 is, for example, but not limited to, a sapphire (Al₂O₃) substrate. Depending on different applications, any transparent substrate with a light transmittance exceeding 90% may be used. It should be noted that, for the sake of clarity in explaining and illustrating the relevant current paths, the substrate 10 applied in the flip-chip structure will be omitted in the following descriptions and drawings.

The epitaxial layer 11 is formed by growing III-V semiconductor materials or II-VI semiconductor materials using a metal-organic chemical vapor deposition (MOCVD) method or a molecular beam epitaxy (MBE) method. For example, the epitaxial layer 11 is formed by alternately stacking gallium arsenide (GaAs) and aluminum arsenide (AlAs). The bandgap of the epitaxial layer 11 ranges from 1.3 to 2.5 eV.

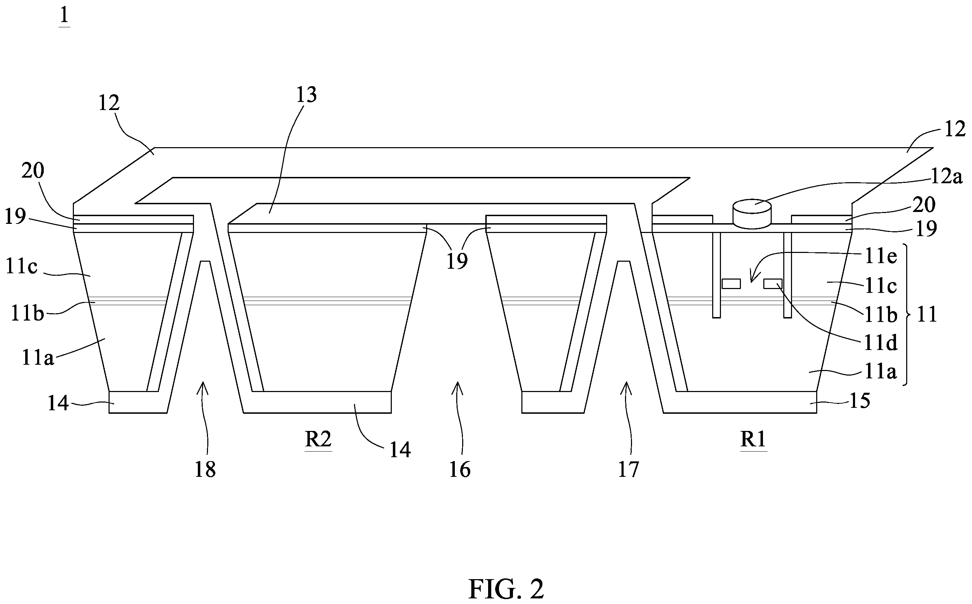

Please also refer to FIG. 2, which shows a cross-sectional schematic view of a light-emitting device in another embodiment of the present invention, wherein it should be noted that, in order to clearly illustrate the spatial positional differences between the first contact electrode 12 and the second contact electrode 13, these two electrodes are specifically depicted in a three-dimensional manner. In a VCSEL device, the epitaxial layer 11 comprises an N-type epitaxial layer 11a, a multiple quantum well layer 11b, and a P-type epitaxial layer 11c, wherein the multiple quantum well layer 11b is disposed on the N-type epitaxial layer 11a, and the P-type epitaxial layer 11c is disposed on the multiple quantum well layer 11b. The N-type epitaxial layer 11a and the P-type epitaxial layer 11c may each be a mirror stack, such as a distributed Bragg reflector (DBR). Furthermore, as shown in FIG. 2, the epitaxial layer 11 further comprises two current barrier layers 11d, disposed in the P-type epitaxial layer 11c and laterally separated from each other by a distance, to form an oxidation aperture (OA) 11e. Each current barrier layer 11d is an insulating layer, which is formed by wet oxidation or ion implantation. The oxidation aperture 11e formed by the current barrier layers 11d is used as a current confinement region for enabling the device to effectively concentrate the current through the oxidation aperture 11e during operation, reducing lateral current diffusion, and confining light to propagate centrally for thereby optimizing optical distribution and improving beam quality and light-emission efficiency of the device.

Please continue to refer to FIG. 1 and FIG. 2, the epitaxial layer 11 of the light-emitting device 1 of the present invention further has a trench 16, longitudinally dividing the epitaxial layer 11 into a first region R1 and a second region R2. In this way, the first region R1 and the second region R2 are configured to be separated from each other. In actual manufacturing processes, the trench 16 may be formed by a wet etching process or a dry etching process. The trench 16 may remain unfilled with any material or may be filled with an elastic material, as long as it can withstand stress to prevent cracking of the epitaxial layer.

The first contact electrode 12 is disposed on the upper surface of the P-type epitaxial layer 11c of the epitaxial layer 11, and through appropriate circuit arrangement, is electrically connected to the P-type epitaxial layer 11c of the first region R1 of the epitaxial layer 11. The first contact electrode 12 comprises an opening 12a. The opening 12a has a radius of approximately 5-10 micrometers (µm), preferably 8 micrometers (µm), and this opening 12a is vertically aligned with the current confinement region of the first region R1, allowing light generated by the multiple quantum well layer 11b to radiate vertically outward through the opening 12a. The first contact electrode 12 is made of a metal material, wherein the metal material is selected from a group consisting of silver (Ag), titanium (Ti), platinum (Pt), germanium gold (GeAu), gold (Au), and combinations thereof. In addition, the second contact electrode 13 is disposed on the upper surface of the P-type epitaxial layer 11c of the second region R2 of the epitaxial layer 11, and is electrically connected to the P-type epitaxial layer 11c of the second region R2. The second contact electrode 13 is made of the same metal material as the first contact electrode 12, which will not be repeated here.

Next, the first metal pad 14 is the P-pad (P-side pad) of the light-emitting device 1, acting as the positive electrode of the flip-chip light-emitting chip, and is disposed under the N-type epitaxial layer 11a of the second region R2 of the epitaxial layer 11, and extends longitudinally to electrically connect to the first contact electrode 12. In addition, the second metal pad 15 is the N-pad (N-side pad) of the light-emitting device 1, acting as the negative electrode of the flip-chip light-emitting chip, and is disposed under the N-type epitaxial layer 11a of the first region R1 of the epitaxial layer 11, and extends longitudinally to electrically connect to the second contact electrode 13. The material of the second metal pad 15 is the same as that of the first metal pad 14, both being made of a metal material selected from a group consisting of silver (Ag), titanium (Ti), platinum (Pt), germanium gold (GeAu), gold (Au), and combinations thereof. In a preferred embodiment, the epitaxial layer 11 further has a first longitudinal through hole 17 and a second longitudinal through hole 18. The first longitudinal through hole 17 vertically penetrates the first region R1 of the epitaxial layer 11, and the second metal pad 15 may fill the first longitudinal through hole 17 or be formed on the sidewall of the first longitudinal through hole 17 for allowing the second metal pad 15 to extend longitudinally and electrically connect to the second contact electrode 13. On the other hand, the second longitudinal through hole 18 vertically penetrates the second region R2 of the epitaxial layer 11, and the first metal pad 14 may fill the second longitudinal through hole 18 or be formed on the sidewall of the second longitudinal through hole 18 for allowing the first metal pad 14 to extend longitudinally and electrically connect to the first contact electrode 12. In particular, the first longitudinal through hole 17 and the second longitudinal through hole 18 may be formed during the manufacturing process by a wet etching process or a dry etching process, and may be formed in the same process stage of the trench 16.

As shown in FIG. 2, the light-emitting device 1 of the present invention further comprises an ohmic contact interface 19, disposed between the P-type epitaxial layer 11c of the epitaxial layer 11 and the first contact electrode 12, and between the P-type epitaxial layer 11c and the second contact electrode 13. In a specific embodiment, the ohmic contact interface 19 is a heavily doped gallium arsenide (GaAs) layer, commonly doped with zinc (Zn), carbon (C), or magnesium (Mg), with a doping concentration typically greater than 10¹⁹ cm⁻³, to ensure the formation of an ohmic contact with low contact resistance at the interface directly contacting the two electrodes.

More specifically, in order to achieve bidirectional surge resistance, the light-emitting device 1 of the present invention further arranges a Schottky interface 20 in the circuit of the device, disposed on the upper surface of the first region R1 outside the current confinement region of the epitaxial layer 11, that is, disposed on the ohmic contact interface 19 of the first region R1 and surrounding the peripheral region of the opening 12a of the first contact electrode 12, as shown in FIG. 2. In a specific embodiment, the Schottky interface 20 is an indium gallium phosphide (InGaP) layer, wherein the indium gallium phosphide (InGaP) layer is typically doped with silicon (Si), selenium (Se), or sulfur (S) as dopants, with a doping concentration of approximately 10¹⁸ cm⁻³, enabling a Schottky barrier to be effectively formed between the Schottky interface 20 and the portion of the first contact electrode 12 directly contacting it, for use to control surge current diversion, as detailed below.

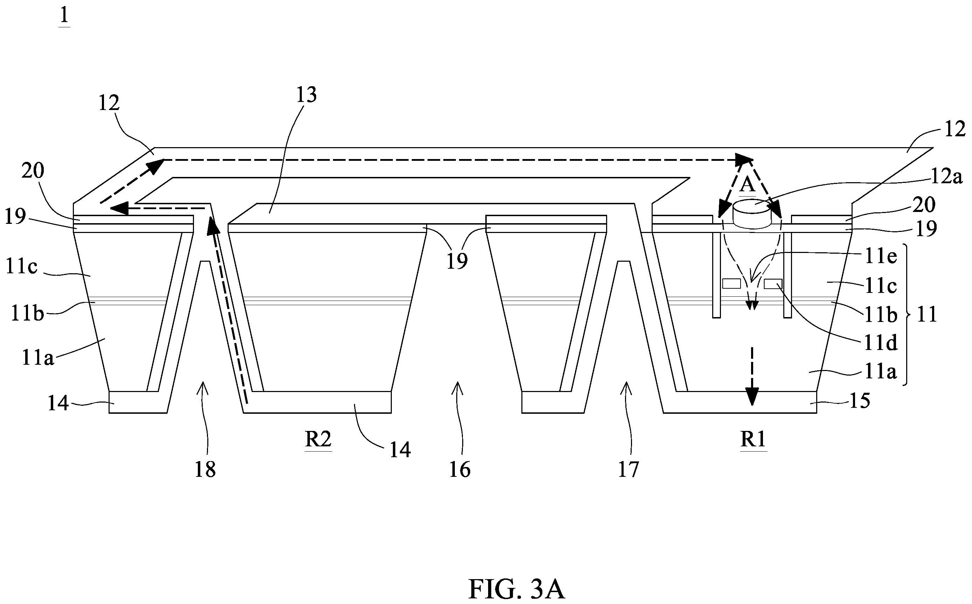

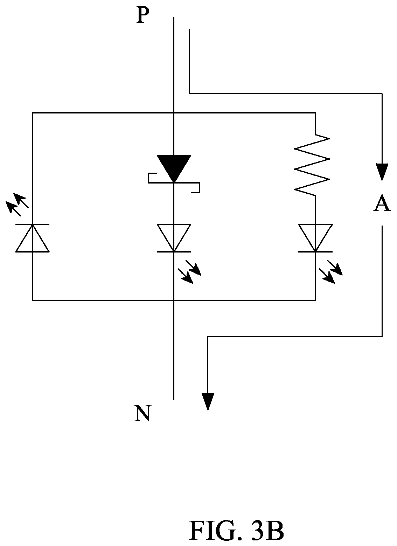

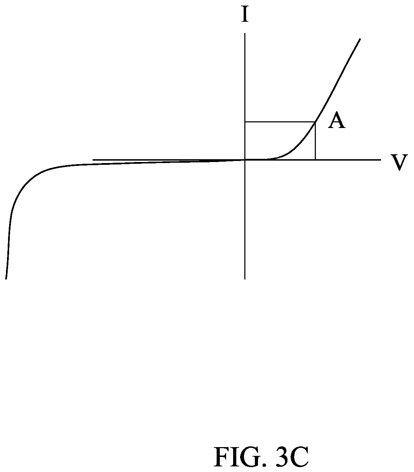

Please refer to FIG. 3A, FIG. 3B, and FIG. 3C, which show a schematic diagram of the current path, an equivalent circuit diagram, and a current-voltage curve of the light-emitting device 1 during normal operation in an embodiment of the present invention. FIG. 3A shows the light-emitting device 1 under a normal current range, that is, within the voltage range of less than 2.5 to 3 volts as indicated by the box in the current-voltage curve shown in FIG. 3C, the current path enters from the first metal pad 14 (P-side pad), passes through the first contact electrode 12 and the ohmic contact interface 19, flows into the oxidation aperture 11e in the current confinement region of the first region R1 and the multiple quantum well layer 11b, and reaches the second metal pad 15 (N-side pad), to excite laser light to emit outward. At this time, under normal current conditions, the equivalent circuit diagram of path A of the light-emitting device 1 can be referred to as shown in FIG. 3B. It should be noted that, at this moment, a Schottky barrier exists between the first contact electrode 12 and the Schottky interface 20, and this barrier can only be overcome and conduct when the turn-on voltage exceeds 3.5 to 4 volts. In other words, during normal operation of the light-emitting device 1, the current path only selects path A as shown in FIG. 3A for flowing into the current confinement region of the first region R1 to excite the laser without selecting other paths.

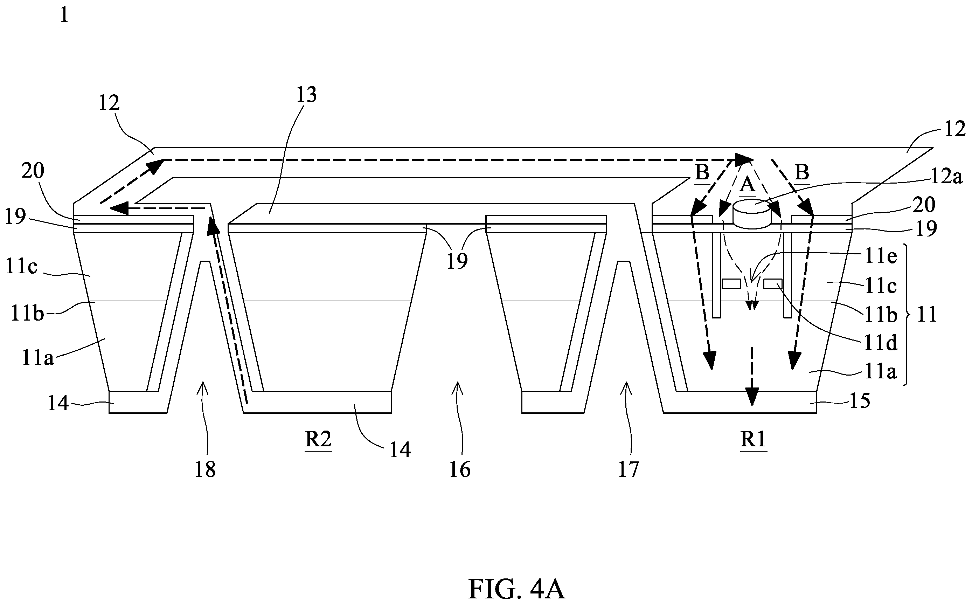

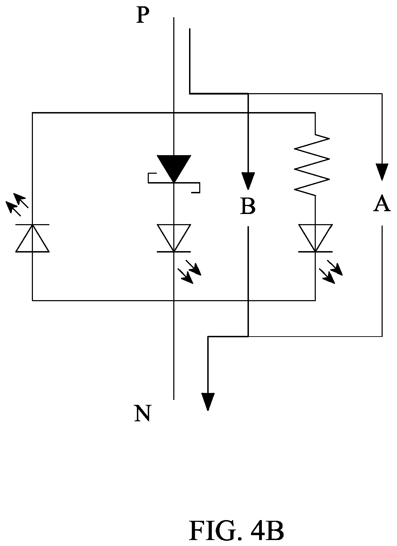

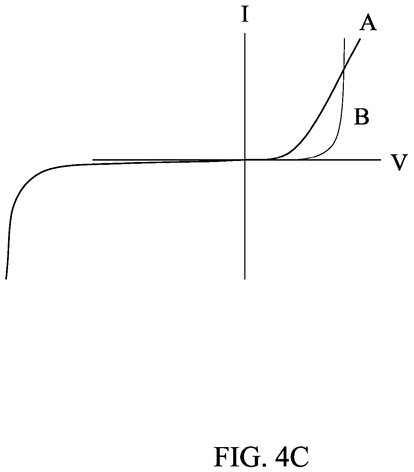

Please refer to FIG. 4A, FIG. 4B, and FIG. 4C, which show a schematic diagram of the current path, an equivalent circuit diagram, and a current-voltage curve of the light-emitting device 1 under a forward surge current in an embodiment of the present invention. FIG. 4A shows that when the light-emitting device 1 encounters an excessively large forward surge current, that is, when the voltage exceeds the normal operating range, for example, greater than 3.5 volts, the current path enters the device from the first metal pad 14 (P-side pad), and the Schottky barrier between the first contact electrode 12 and the Schottky interface 20 will be overcome and conduct to produce a current splitting effect. As shown in FIG. 4B, most of the forward surge current will pass through path B, that is, the region of the first region R1 outside the current confinement region, and reach the second metal pad 15 (N-side pad). On the other hand, after splitting, the remaining portion of the forward surge current will pass through path A via the oxidation aperture 11e, and reach the second metal pad 15 (N-side pad). At this time, under the forward surge circuit, the current-voltage curves of paths A and B are as shown in FIG. 4C. It should be noted that the reason why most of the forward surge current selects path B instead of path A is that the resistance of path B is much lower than that of path A for thereby guiding most of the forward surge current to avoid the oxidation aperture 11e of the current confinement region, preventing the laser chip from failing due to excessive current concentration in path A, which generates excessive Joule heat and causes the device burnout.

It is further explained that, provided the Schottky barrier of the Schottky interface 20 is overcome, the reason why the resistance of path B is much lower than that of path A lies in the fact that in the light-emitting device 1 of the present invention, the area of the peripheral region of the opening 12a of the first contact electrode 12 directly contacting a portion of the ohmic contact interface 19 (i.e., the area surrounding the periphery of the opening 12a above the current confinement region in the first region R1) is approximately 75-100 square micrometers (µm²); on the other hand, the area of the region of the first contact electrode 12 contacting the Schottky interface 20 is approximately 5000 square micrometers (µm²), and comparing the resistances calculated from the contact areas of the two, it can be seen that the resistance of the Schottky interface 20 in path B is much lower than the contact resistance formed by the ohmic contact interface 19 in the peripheral region of the opening 12a in path A. Therefore, most of the forward surge current will select path B, while a small portion of the current will select path A for thereby achieving the effect of splitting the current and protecting the device.

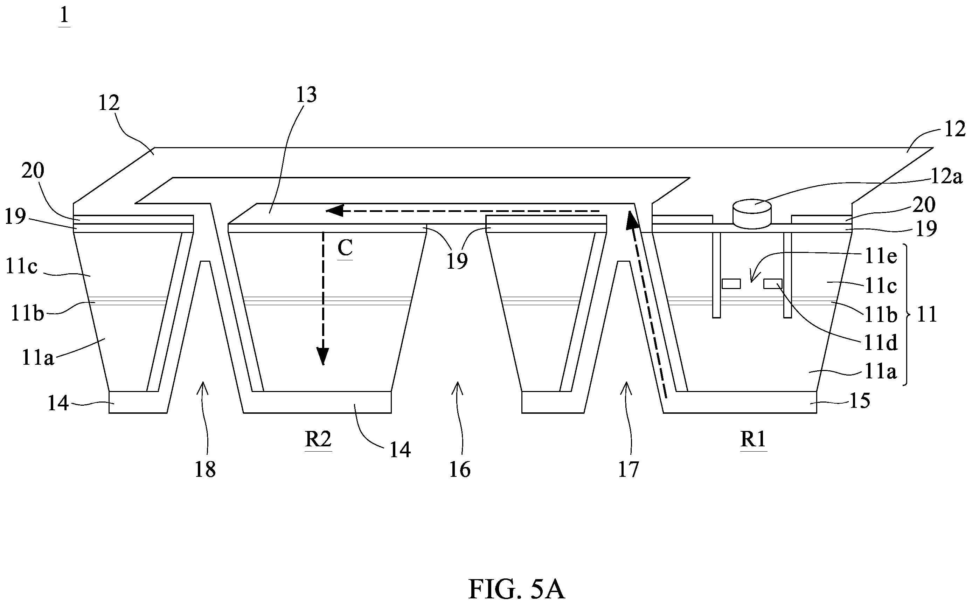

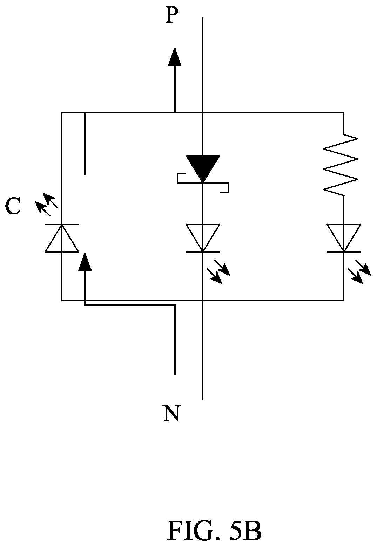

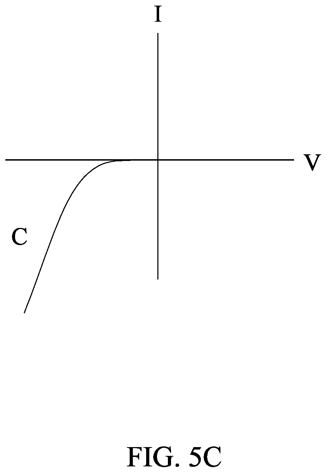

Please refer to FIG. 5A, FIG. 5B, and FIG. 5C, which show a schematic diagram of the current path, an equivalent circuit diagram, and a current-voltage curve of the light-emitting device 1 when encountering a reverse surge current in an embodiment of the present invention. FIG. 5A shows that when the light-emitting device 1 encounters a reverse surge current, the reverse surge current will select path C to enter the device from the second metal pad 15 (N-side pad), flow into the second region R2 via the second contact electrode 13, and then be safely dissipated from the first metal pad 14 (P-side pad) to remove the abnormal reverse surge current. The equivalent circuit of the light-emitting device under path C is as shown in FIG. 5B, and this reverse surge current will not select path A to enter the current confinement region in the first region R1 to achieve the effect of protecting the device from damage by the reverse surge circuit. The current-voltage curve of the light-emitting device 1 of the present invention under a reverse surge current can be referred to in the negative voltage range as shown in FIG. 5C.

It should be noted that, at this moment, the reason why the reverse surge current selects path C as shown in FIG. 5A when flowing into the second metal pad 15 (N-side pad) is that, when the reverse surge current flows in from the second metal pad 15 (N-side pad), in path C, the reverse surge current only needs to overcome the forward bias of the PN junction from the P-type epitaxial layer 11c to the N-type epitaxial layer 11a within the second region R2. Conversely, if in path A (and/or path B), the reverse surge current would need to overcome the large reverse bias of the PN junction from the N-type epitaxial layer 11a to the P-type epitaxial layer 11c within the first region R1. Comparing the differences in the biases that need to be overcome in the two paths, the reverse surge current will naturally be guided to path C, passing through the second region R2 and then being safely dissipated from the first metal pad 14 (P-side pad). In other words, it naturally avoids the reverse surge current entering the current confinement region in the first region R1 to achieve the effect of protecting the device from damage by the reverse surge circuit.

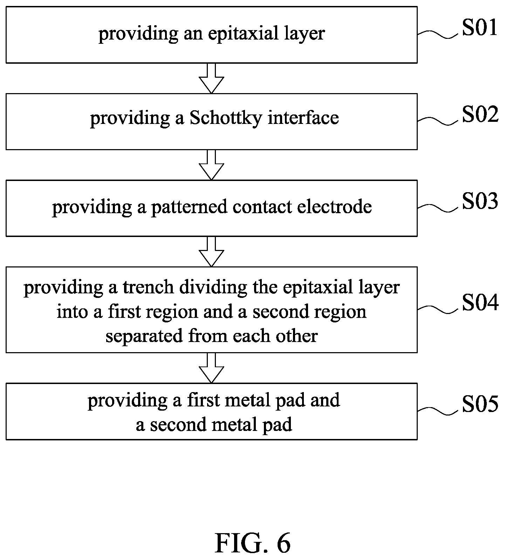

Please refer to FIG. 6, which shows a manufacturing method for manufacturing the VCSEL light-emitting device of the present invention. First, in step S01, provide an epitaxial layer formed on an epitaxial growth substrate. In step S02, provide a Schottky interface, disposed on a portion of the epitaxial layer. In addition, before the step of providing a Schottky interface, further comprise a step of providing an ohmic contact interface disposed on the epitaxial layer, wherein an ohmic contact is formed between the portion of the ohmic contact interface outside the Schottky interface and the first contact electrode directly contacting it. In step S03, provide a contact electrode, disposed on the Schottky interface and on the other portion of the epitaxial layer outside the Schottky interface. Next, pattern the contact electrode to form a first contact electrode and a second contact electrode electrically isolated from each other, wherein the first contact electrode comprises an opening, and a Schottky barrier is formed between the portion of the first contact electrode and the Schottky interface directly contacting it. Then, in step S04, provide a trench, longitudinally dividing the epitaxial layer into a first region and a second region separated from each other, wherein the first contact electrode is electrically connected to the upper surface of the first region, the second contact electrode is electrically connected to the upper surface of the second region, and the first region has a current confinement region below the opening. It should be noted that, before performing the trench process, it is necessary to first perform a substrate transfer, bonding the epitaxial layer to a permanent substrate and then removing the original epitaxial growth substrate, followed by wafer flipping and then performing the trench etching process. Finally, in step S05, provide a first metal pad and a second metal pad, wherein the first metal pad is disposed under the second region of the epitaxial layer, and extends longitudinally to electrically connect to the first contact electrode. The second metal pad is disposed under the first region of the epitaxial layer, and extends longitudinally to electrically connect to the second contact electrode. In addition, the step of providing a first metal pad is to fill an appropriate metal material after providing a second longitudinal through hole penetrating the second region of the epitaxial layer. Similarly, the step of providing a second metal pad is to fill the same metal material after providing a first longitudinal through hole penetrating the first region of the epitaxial layer. Relevant detailed descriptions can refer to the foregoing content and will not be repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A light-emitting device, comprising:
an epitaxial layer, having a trench, longitudinally dividing the epitaxial layer into a first region and a second region separated from each other;
a first contact electrode, disposed on the epitaxial layer and having an opening electrically connected to the upper surface of the first region, wherein the first region has a current confinement region below the opening;
a Schottky interface, disposed on the upper surface of the first region outside the current confinement region, and forming a Schottky barrier between the Schottky interface and a portion of the first contact electrode;
a first metal pad, disposed under the second region of the epitaxial layer and extending longitudinally to electrically connect to the first contact electrode;
a second contact electrode, disposed on the epitaxial layer and electrically connected to the upper surface of the second region; and
a second metal pad, disposed under the first region of the epitaxial layer and extending longitudinally to electrically connect the second contact electrode.

2. The light-emitting device of the previous claim, wherein when a forward surge current flows into the first metal pad and the first contact electrode, the forward surge current overcomes the Schottky barrier for causing most of the forward surge current to flow through the Schottky interface into the other region of the first region outside the current confinement region, and the rest of the forward surge current flows into the current confinement region.

3. The light-emitting device of any of the previous claims, wherein when a reverse surge current flows into the second metal pad and the second contact electrode, the reverse surge current totally flows into the second region without reversely flowing into the current confinement region.

4. The light-emitting device of any of the previous claims, wherein the Schottky interface is an indium gallium phosphide (InGaP) layer.

5. The light-emitting device of any of the previous claims, further comprising an ohmic contact interface disposed on the epitaxial layer, wherein an ohmic contact is formed between the portion of the ohmic contact interface outside the Schottky interface and the first contact electrode.

6. The light-emitting device of the previous claim, wherein the ohmic contact interface is a heavily doped gallium arsenide (GaAs) layer.

7. The light-emitting device of any of the previous two claims, wherein the epitaxial layer comprises:
an N-type epitaxial layer;
a multiple quantum well layer, disposed on the N-type epitaxial layer;
a P-type epitaxial layer, disposed on the multiple quantum well layer; and
two current barrier layers, disposed in the P-type epitaxial layer and laterally separated from each other by a distance,
wherein the first metal pad is disposed under the N-type epitaxial layer in the second region, and the second metal pad is disposed under the N-type epitaxial layer in the first region,
wherein the ohmic contact interface is disposed on the P-type epitaxial layer.

8. The light-emitting device of any of the previous claims, wherein the first region of the epitaxial layer has a first longitudinal through hole, and the second metal pad extends longitudinally along the first longitudinal through hole to be electrically connected to the second contact electrode.

9. The light-emitting device of any of the previous claims, wherein the second region of the epitaxial layer has a second longitudinal through hole, and the first metal pad extends longitudinally along the second longitudinal through hole to be electrically connected to the first contact electrode.

10. The light-emitting device of any of the previous claims, wherein the materials of the first contact electrode and the second contact electrode are selected from a group consisting of silver (Ag), titanium (Ti), platinum (Pt), germanium gold (GeAu), gold (Au) and combinations thereof.

11. A manufacturing method of a light-emitting device, comprising:
providing an epitaxial layer;
providing a Schottky interface, disposed on a portion of the epitaxial layer;
providing a contact electrode, disposed on the Schottky interface and on the other portion of the epitaxial layer outside the Schottky interface;
patterning the contact electrode to form a first contact electrode and a second contact electrode, wherein the first contact electrode has an opening and forms a Schottky barrier between the Schottky interface and a portion of the first contact electrode;
providing a trench, longitudinally dividing the epitaxial layer into a first region and a second region separated from each other, wherein the first contact electrode is electrically connected to the upper surface of the first region, the second contact electrode is electrically connected to the upper surface of the second region, and the first region has a current confinement region below the opening;
providing a first metal pad, disposed under the second region of the epitaxial layer and extending longitudinally to electrically connect to the first contact electrode; and
providing a second metal pad, disposed under the first region of the epitaxial layer and extending longitudinally to electrically connect the second contact electrode.

12. The manufacturing method of a light-emitting device of the previous method claim, wherein the step of providing a Schottky interface is to provide an indium gallium phosphide (InGaP) layer.

13. The manufacturing method of a light-emitting device of any of the previous method claims, further comprising a step of providing an ohmic contact interface disposed on the epitaxial layer, wherein an ohmic contact is formed between the portion of the ohmic contact interface outside the Schottky interface and the first contact electrode before the step of providing a Schottky interface.

14. The manufacturing method of a light-emitting device of previous method claim, wherein the step of providing an ohmic contact interface disposed on the epitaxial layer is to provide a heavily doped gallium arsenide (GaAs) layer disposed on the epitaxial layer.

15. The manufacturing method of a light-emitting device of any of the previous method claims, wherein the step of providing a first metal pad is to fill a material selected from a group consisting of silver (Ag), titanium (Ti), platinum (Pt), germanium gold (GeAu), gold (Au) and their combinations thereof after providing a second longitudinal through hole penetrating the second region of the epitaxial layer, and/or wherein the step of providing a second metal pad is to fill a material selected from a group consisting of silver (Ag), titanium (Ti), platinum (Pt), germanium gold (GeAu), gold (Au) and their combinations thereof after providing a first longitudinal through hole penetrating the first region of the epitaxial layer.
